# EUROPÄISCHE PATENTSCHRIFT

(11) **EP 0 473 976 B1**
(45) Veröffentlichungstag und Bekanntmachung des Hinweises auf die Patenterteilung: **30.11.1994**
(21) Anmeldenummer: 91113514.3
(22) Anmeldetag: 12.08.1991
(51) Int. Cl.: H01L 21/60, H05K 13/04

(54) **Verfahren und Vorrichtung zum Verbinden eines Halbleiterchips mit einem Trägersystem**
Method and apparatus to bond a semiconductor chip to a carrier
Procédé et dispositif pour attacher une pièce semiconductrice sur une bande de support

(30) Priorität: 23.08.1990 DE 4026668
(43) Veröffentlichungstag der Anmeldung: 11.03.1992
(73) Patentinhaber: SIEMENS AKTIENGESELLSCHAFT, 80333 München (DE)
(72) Erfinder: Scheuenpflug, Richard, W-8411 Kleinprüfeningen (DE)

(56) Entgegenhaltungen:
- EP-A- 0 305 964
- DE-A- 2 117 399
- FR-A- 2 313 772
- FR-A- 2 492 164
- US-A- 3 887 996

## Beschreibung

Verfahren und Vorrichtung zum Verbinden eines Halbleiterchips mit einem Trägersystem

Die Erfindung betrifft ein Verfahren nach dem Oberbegriff des Anspruchs 1 und eine Vorrichtung nach dem Oberbegriff des Anspruchs 5.

Es ist bekannt, zur automatischen Montage von Halbleiterchips bzw. monolithischen Mikrobausteinen auf einen Montageträger einen sogenannten Die-Bonder bzw. Chip-Bonder zu benutzen. Dieser arbeitet nach dem "pick up"-Prinzip, d.h. der bereits vereinzelte, aber noch im Waferverband befindliche und auf selbstklebende Folie aufgebrachte Halbleiterchip wird von unten mit einer "pick up"-Nadel angehoben. Der angehobene Chip wird dann mit einer Vakuumsaugpinzette in Richtung der Z-Achse, d.h. vertikal, abgehoben und mit linearer und/oder rotierender Bewegung in Position des Montageträgers, beispielsweise eines Leadframes gebracht. Mit einer weiteren Bewegung in Z-Richtung abwärts wird dann der Chip auf den Montageträger bzw. das Trägersystem aufgesetzt. Die Verbindung erfolgt durch Legieren, Löten oder Kleben.

Durch dieses Prinzip sind allerdings je nach Applikation mehr oder weniger lange Wege von der Chipposition zur Montageposition erforderlich. Der heute bekannte kürzeste Zyklus beträgt 0,4s bis 0,6s pro Chip. Zudem wird zur Abnahme und zum Übertrag eines jeweiligen Chips eine Saugpinzette benötigt. Beschädigungen des Halbleiterkristalls und Störungen durch Partikel sowie Verschleiß des Bondkopfes sind durch dieses Prinzip bedingt. Insgesamt gesehen ist dieses Chipübertragungssystem zu aufwendig, insbesondere im Hinblick auf Zeit, Kosten und Materialverschleiß.

Weitere Verfahren und Vorrichtungen sind in FR-A-2313772 und US-A-3887996 beschrieben.

Der Erfindung liegt die Aufgabe zugrunde, ein Verfahren und eine Vorrichtung anzugeben, nach welchen die Aufbringung des Halbleiterchips auf ein Trägersystem mit wesentlich weniger Zeit- und Investmentaufwand auskommt.

Diese Aufgabe wird erfindungsgemäß durch ein Verfahren mit den Merkmalen des Anspruchs 1 und eine Vorrichtung mit den Merkmalen des Anspruchs 5 gelöst.

Vorteilhafte Ausgestaltungen bzw. Weiterbildungen der Erfindung sind Gegenstand zusätzlicher Ansprüche.

Bei der Erfindung wird davon ausgegangen, daß ein bereits vereinzelter, aber noch im Waferverband auf einer Klebefolie befindlicher Halbleiterchip in geringem Abstand über den Montageträger bzw. das Trägersystem gebracht wird. Der Waferverband auf der Selbstklebefolie wird so ausgerichtet bzw. justiert, daß die zu verbindende Fläche des Chips der Verbindungsstelle des Trägers gegenüberliegt. Mit einem "push down pin" wird der Chip aus dem Waferverband gestoßen und über eine kurze Distanz von ≦0,2mm auf das vorzugsweise mit Kleber als Verbindungsmaterial im Bondbereich bedruckte Trägersystem gebracht. Die Adhäsionskräfte des Klebers reichen aus, den durch den Ausstoßvorgang nur noch gering an der Folie haftenden Chip zu übernehmen. Dieses Verfahren eignet sich besonders für zwei Arten des Chipverbindens mit einem Trägersystem, nämlich einerseits zu einer face-up- bzw. upside-up-Montage und andererseits zu einer upside-down- bzw. face-down-Montage bzw. Flip Chip Bonding.

Bei der einen Verfahrensvariante wird der Chip mit der Rückseite mit dem Halbleiterträger bzw. Trägersystem verbunden. Dazu wird der Wafer im herkömmlichen Verfahren gesägt, und zwar auf eine Restdicke von 10µm bis 30µm. Der auf einer Folie befindliche Wafer wird nun samt der Folie aus einem Ring geschnitten, in den die Folie eingespannt ist und mit der Oberseite auf eine bereitliegende, selbstklebende Folie geklebt. Die auf der Rückseite noch befindliche Folie wird nun in einem "peel"-Vorgang abgezogen. Auch Verfahren zur Reduzierung der Klebekraft, z.B. durch UV-Bestrahlung sind möglich. Der so präparierte Wafer wird auf einen Waferhalter auf einem motorisch getriebenen X-Y-Tisch gebracht. Mit Hilfe eines optoelektronischen Systems wird der Wafer ausgerichtet und der erste Chip in Bondposition gebracht. Die optoelektronische Achse ist vorher mit der mechanischen Bondposition abzugleichen. Der Montageträger bzw. das Trägersystem wird nun in Bondposition gebracht, zentriert und fixiert. Dann wird der erste Chip ansgestoßen und am Trägersystem fixiert. Eine weitere Justage der Chips über dem Trägersystem in der Folge ist nicht mehr erforderlich, da die vom Sägeprozeß vorgegebene Rasterung und die Schrittgenauigkeit des X-Y-Tisches von ±2,5µm ausreicht, die Chips "blind" zu bonden. Sollen "geinkte" Wafer, d.h. mit fehlerhaften, markierten Chips versehene Wafer verarbeitet werden, so ist hier ein sogenanntes "wafer mapping" vorgesehen, d.h. die Positionen von "Gut"- und "Schlecht"-Chips werden beim Endmessen auf einen dem Wafer zugeordneten Datenträger übertragen. Der Die-Bonder benötigt dann eine entsprechende Einrichtung, um diese Informationen zu verarbeiten.

Bei der anderen Verfahrensvariante wird der Chip mit der Vorderseite mit dem Halbleiterträger bzw. Trägersystem verbunden. Man bezeichnet diese Art der Chipmontage auch als Flip-Chip-Bonding. Hier kann der gesägte Wafer direkt face down in die Waferaufnahme des X-Y-Tisches eingesetzt werden. Bei einem entsprechend gestalteten Trägersystem (Montageträger) kann mit einem optoelektronischen System der Chip direkt über die Anschlußpositionen des Trägersystems (Halbleiterträgers) justiert werden. Die Chips sind dazu zweckmäßig mit einer Justiermarke versehen. Diese Maßnahme dient zur Erhöhung der Genauigkeit der Positionierung des Halbleiterchips auf den Anschlußkontakthöckern (Bumps) des Trägersystems, um Chip- und Kontakt-(Pad-)größe möglichst klein zu halten. Wird der aufgebrachte Flip-Chip nicht von einem Gehäuse umgeben, so wird durch einen Kunststoffverguß (z.B. Epoxidharz) eine mechanische Stabilisierung erzeugt.

Die mit der Erfindung erzielten Vorteile bestehen insbesondere darin, daß mit diesem Verfahren und dieser Vorrichtung Zykluszeiten von ≦0,1s/Chip erreicht werden. Der bisher übliche Bondkopf, eines der aufwendigsten und wegen der hohen Beschleunigungskräfte am meisten verschleißenden Teile der Bondvorrichtung, kann somit entfallen. Ebenso wird eine Saugpinzette zur Übertragung des Halbleiterchips von der Selbstklebefolie auf das Trägersystem nicht mehr benötigt.

Anhand eine in den Figuren der Zeichnung dargestellten Ausführungsbeispieles wird die Erfindung im folgenden näher erläutert. Es zeigen:
- FIG 1: eine Vorrichtung zum Verbinden eines Halbleiterchips mit einem Trägersystem und
- FIG 2: einen Ausschnitt der Vorrichtung im Betriebszustand des Chipausstoßens.

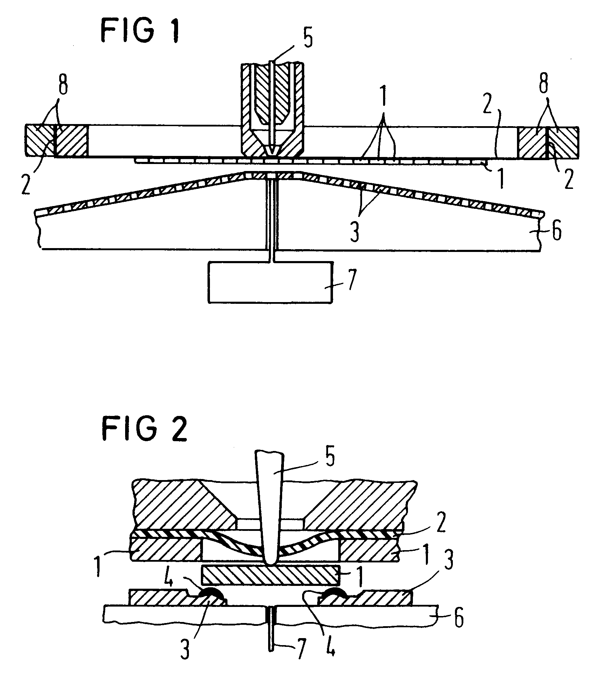

Die in den FIG 1 und FIG 2 dargestellte Vorrichtung zum Verbinden eines Halbleiterchips 1 mit einem Trägersystem 3 besteht im wesentlichen aus einem X-Y-Tisch 6 zur Aufnahme und Führung des Trägersystems 3, der mit einer optoelektronischen Justiervorrichtung 7 gekoppelt ist, und aus einer Stoßvorrichtung 5 zum Ausstoßen jeweils eines bereits vereinzelten Halbleiterchips 1 aus einem Waferverband, der auf einer Selbstklebefolie 2 befestigt ist. Die Selbstklebefolie 2 ist mit den noch im Waferverband befindlichen Halbleiterchips 1 in einem Spannring 8 festgespannt. Das Trägersystem 3, beispielsweise ein Leiterband, ein sogenannter Leadframe oder ein Flip Chip Träger, ist an vorgegebenen Verbindungsstellen mit einem Verbindungsmaterial 4 (FIG 2), vorzugsweise einem Leitkleber, z.B. einem Silberleitkleber, versehen. Der vereinzelte, im Waferverband auf der Selbstklebefolie 2 befindliche Halbleiterchip 1 ist in einem geringen Abstand von ≦0,2mm über das auf dem X-Y-Tisch 6 geführte Trägersystem 3 gebracht. Dabei wird der Waferverband mittels der optoelektronischen Justiereinrichtung 7 zu dem auf dem X-Y-Tisch geführten Trägersystem 3 so ausgerichtet, daß die zu verbindende Fläche eines Halbleiterchips 1 einer mit Kleber als Verbindungsmaterial 4 versehenen Stelle des Trägersystems 3 gegenüberliegt. Zum Herausstoßen des Halbleiterchips 1 aus dem Waferverband in Richtung auf die mit Kleber 4 versehene Stelle bzw. Stellen des Trägersystems 3 ist die Stoßvorrichtung 5 über dem X-Y-Tisch angeordnet, wobei Waferverband bzw. Chipanordnung und Trägersystem 3 zwischengeordnet sind.
FIG 2 veranschaulicht den Ausstoßvorgang. Die Adhäsionskräfte des Klebers 4 reichen aus, den durch den Ausstoßvorgang nur noch gering an der Folie 2 haftenden Chip 1 zu übernehmen. Die Stoßvorrichtung 5 besteht zweckmäßig aus einem Druckstift, d.h. aus einem sogenannten push down pin, der elektromechanisch betrieben wird.

## Patentansprüche

1. Verfahren zum Verbinden eines Halbleiterchips mit einem Trägersystem, bei dem der bereits vereinzelte, noch im Waferverband befindliche und auf eine Selbstklebefolie aufgebrachte Halbleiterchip von dieser gelöst und auf eine vorgegebene Verbindungsstelle auf dem Trägersystem aufgebracht und mit diesem verbunden wird, wobei das Trägersystem (3) an der vorgegebenen Verbindungsstelle mit einem Verbindungsmaterial (4) versehen wird, der vereinzelte, im Waferverband auf Selbstklebefolie (2) befindliche Halbleiterchip (1) in einem geringen Abstand von ≦0,2mm über das Trägersystem (3) gebracht wird, der Waferverband so ausgerichtet wird, daß die zu verbindende Fläche eines Halbleiterchips (1) einer mit Verbindungsmaterial (4) versehenen Stelle des Trägersystems (3) gegenüberliegt, und der Halbleiterchip (1) mittels einer Stoßvorrichtung (5) aus dem Waferverband auf die mit Verbindungsmaterial (4) versehene Verbindungsstelle des Trägersystems (3) gestoßen und mit diesem verbunden wird.

2. Verfahren nach Anspruch 1, **dadurch gekennzeichnet**, daß als Verbindungsmaterial (4) ein Kleber verwendet wird.

3. Verfahren nach Anspruch 1 oder 2, **dadurch gekennzeichnet**, daß als Verbindungsmaterial (4) ein Leitkleber verwendet wird.

4. Verfahren nach einem der Ansprüche 1 bis 3, **dadurch gekennzeichnet**, daß ein im Waferverband auf der Selbstklebefolie (2) befindlicher Halbleiterchip (1) mittels einer optoelektronischen Justiervorrichtung (7) und eines X-Y-Tisches (6) so ausgerichtet wird, daß die zu verbindende Fläche des Halbleiterchips (1) einer mit Verbindungsmaterial (4) versehenen Stelle des Trägersystems (3) gegenüberliegt.

5. Vorrichtung in Verbindung mit einem Trägersystem, das an der vorgegebenen Verbindungsstelle mit einem Verbindungsmaterial (4) versehen ist und mit bereits vereinzelten, noch im Waferverband befindlichen und auf eine Selbstklebefolie aufgebrachten Halbleiterchips um jeweils einen einzelnen Chip von der Selbstklebefolie zu lösen und auf eine vorgegebene Verbindungsstelle auf dem Trägersystem aufzubringen und mit diesem zu verbinden, wobei der vereinzelte, im Waferverband auf Selbstklebefolie (2) befindliche Halbleiterchip (1) in einen geringen Abstand von ≦0,2mm über das auf einem X-Y-Tisch (6) geführte Trägersystem (3) gebracht ist, der Waferverband mittels einer optoelektronischen Justiereinrichtung (7) zu dem auf dem X-Y-Tisch (6) geführten Trägersystem (3) so ausgerichtet ist, daß die zu verbindende Fläche des Halbleiterchips (1) der mit Verbindungsmaterial (4) versehenen Stelle des Trägersystems (3) gegenüberliegt, und eine Stoßvorrichtung (5) zum Stoßen des Halbleiterchips (1) aus dem Waferverband auf die mit Verbindungsmaterial (4) versehene Stelle des Trägersystems (3) vorgesehen ist.

6. Vorrichtung nach Anspruch 5, **dadurch gekennzeichnet**, daß das Trägersystem (3) ein Leiterband ist.

7. Vorrichtung nach Anspruch 5, **dadurch gekennzeichnet**, daß das Trägersystem (3) ein Flip-Chip-Träger ist.

8. Vorrichtung nach einem der Ansprüche 5 bis 7, **dadurch gekennzeichnet**, daß die Stoßvorrichtung (5) ein Druckstift ist.

## Claims

1. Method for bonding a semiconductor chip to a carrier system, in which the semiconductor chip, which is already separated, is still in the wafer array and is attached to a self-adhesive foil, is detached from the latter and is applied to a predetermined bonding position on the carrier system and is bonded to it, the carrier system (3) being provided with a bonding material (4) at the predetermined bonding location, the separated semiconductor chip (1), located on self-adhesive foil (2) in the wafer array, being bought above the carrier system (3) at a short distance of ≦ 0.2 mm, the wafer array being aligned in such a manner that the surface of a semiconductor chip (1) to be bonded is opposite to a location of the carrier system (3) provided with bonding material (4), and the semiconductor chip (1) being pushed by means of a pushing device (5) out of the wafer array onto the bonding location, provided with bonding material (4), of the carrier system (3) and being bonded to it.

2. Method according to Claim 1, characterized in that an adhesive is used as bonding material (4).

3. Method according to Claim 1 or 2, characterized in that a conductive adhesive is used as bonding material (4).

4. Method according to one of Claims 1 to 3, characterized in that a semiconductor chip (1), which is located in the wafer array on the self-adhesive foil (2), is aligned by means of an optoelectronic alignment device (7) and an X/Y table (6) in such a manner that the surface of the semiconductor chip (1) to be bonded is opposite to a location of the carrier system (3) provided with bonding material (4).

5. Device in connection with a carrier system which is provided with a bonding material (4) at the predetermined bonding location and with semiconductor chips which are already separated, are still in the wafer array and are attached to a self-adhesive foil, in order to detach in each case a single chip from the self-adhesive foil and to apply it to a predetermined bonding location on the carrier system and to bond it therewith, the separated semiconductor chip (1) located in the wafer array on self-adhesive foil (2) being brought above the carrier system (3), guided on an X/Y table (6), at a short distance of ≦ 0.2 mm, the wafer array being aligned with respect to the carrier system (3) guided on the X/Y table (6) by means of an optoelectronic alignment device (7) in such a manner that the surface of the semiconductor chip (1), which is to be bonded, is opposite to the location of the carrier system (3) provided with bonding material (4), and a pushing device (5) is provided for pushing the semiconductor chip (1) out of the wafer array onto the location of the carrier system (3) provided with bonding material (4).

6. Device according to Claim 5, characterized in that the carrier system (3) is a conductor strip.

7. Device according to Claim 5, characterized in that the carrier system (3) is a flip chip carrier.

8. Device according to one of Claims 5 to 7, characterized in that the pushing device (5) is a pressure pin.

## Revendications

1. Procédé pour réunir une plaquette à semiconducteurs à un système de support, selon lequel on détache la microplaquette à semiconducteurs, déjà individualisée, encore située dans l'ensemble mère de pastilles et déposée sur une feuille auto-adhésive, de cette feuille auto-adhésive, et on la dépose à l'emplacement prédéterminé de liaison sur le système de support et on la réunit à ce système, et selon lequel on équipe le système de support (3) d'un matériau de liaison (4) au niveau de l'emplacement de liaison prédéterminé, on dépose la microplaquette à semiconducteurs (1) séparée et située dans l'ensemble mère de pastilles, sur la feuille auto-adhésive (2), à une faible distance ≦ 0,2 mm au-dessus du système de support (3), on aligne l'ensemble mère de pastilles de telle sorte que la surface à réunir d'une plaquette à semiconducteurs (1) est située en vis-à-vis d'un emplacement, pourvu du matériau de liaison (4), du système de support (3) et qu'on repousse, au moyen d'un dispositif de poussée (5), la microplaquette à semiconducteurs (1) à partir de l'ensemble mère de pastilles, sur l'emplacement de liaison, pourvu du matériau de liaison (4), du système de support (3) et on la réunit à ce dernier.

2. Procédé suivant la revendication 1, caractérisé par le fait qu'on utilise un adhésif comme matériau de liaison (4).

3. Procédé suivant la revendication 1 ou 2, caractérisé par le fait qu'on utilise une colle conductrice comme matériau de liaison (4).

4. Procédé suivant l'une des revendications 1 à 3, caractérisé par le fait qu'une microplaquette à semiconducteurs (1), située dans l'ensemble mère de pastilles sur la feuille auto-adhésive (2), est alignée, au moyen d'un dispositif d'ajustement optoélectronique (7) et une table X-Y (6) de telle sorte que la surface à réunir de la microplaquette à semiconducteurs (1) est située en vis-à-vis d'une zone, pourvue d'un matériau de liaison (4), du système de support (3).

5. Dispositif en liaison avec un système de support, qui comporte, au niveau de l'emplacement de liaison prédéterminé, un matériau de liaison (4), et comportant des microplaquettes à semiconducteurs déjà individualisées, situées encore dans l'ensemble mère de pastilles et déposées sur une feuille auto-adhésive, pour détacher respectivement une microplaquette individualisée, de la feuille auto-adhésive et la déposer en un emplacement prédéterminé de liaison sur le système de support et la réunir à ce système, et dans lequel la microplaquette à semiconducteurs individualisés (1), située dans l'ensemble mère de pastilles sur la feuille auto-adhésive (2) est placée à une faible distance ≦ 0,2 mm au-dessus du système de support (3) guidé sur une table X-Y (6), l'ensemble mère de pastilles est orienté au moyen d'un dispositif d'ajustement optoélectronique (7) sur le système de support (3) guidé sur la table X-Y (6), que la surface à réunir de la microplaquette à semiconducteurs (1) est située en vis-à-vis de l'emplacement, pourvu du matériau de liaison (4), du système de support (3), et qu'il est prévu un dispositif de poussée (5) servant à repousser la microplaquette à semiconducteurs (1) à partir de l'ensemble mère de pastilles contre l'emplacement, pourvu du matériau de liaison (4), du système de support (3).

6. Dispositif suivant la revendication 5, caractérisé par le fait que le système de support (3) est une bande conductrice.

7. Dispositif suivant la revendication 5, caractérisé par le fait que le système de support (3) est un support Flip-Chip.

8. Dispositif suivant l'une des revendications 5 à 7, caractérisé par le fait que le dispositif de poussée (5) est une tige d'éjection.
